# EUROPÄISCHE PATENTANMELDUNG

(11) **EP 4 648 290 A1**
(43) Veröffentlichungstag der Anmeldung: **12.11.2025**
(21) Anmeldenummer: 25173055.2
(22) Anmeldetag: 28.04.2025
(51) Int. Cl.: H03M 3/00, G01D 3/02, G01R 19/00, G01R 19/25

(54) **VORRICHTUNG UND VERFAHREN ZUR ERFASSUNG UND ÜBERWACHUNG EINER ANALOGEN MESSGRÖSSE**

(30) Priorität: 06.05.2024 DE 102024204230
(71) Anmelder: VOLKSWAGEN AKTIENGESELLSCHAFT, 38440 Wolfsburg (DE)
(72) Erfinder: Homann, Michael, 38440 Wolfsburg (DE)

(57) **Zusammenfassung**

Die Erfindung betrifft eine Vorrichtung (1) zur Erfassung und Überwachung einer analogen Messgröße, wobei die Vorrichtung (1) mindestens einen Sensor (2) zur Erfassung der analogen Messgröße, einen analogen Eingangsfilter (5), einen Delta-Sigma-Modulator (6), einen nachgeordneten Filter (7) und eine Vergleichseinheit (8) aufweist, wobei der Delta-Sigma-Modulator (6) derart ausgebildet ist, dem nachgeordneten Filter (7) einen Bitstrom (BS) zuzuführen, wobei Delta-Sigma-Modulator (6) und Filter (7) synchron getaktet sind, wobei zwischen dem Delta-Sigma-Modulator (6) und dem Filter (7) eine Umschalteinrichtung (11) angeordnet ist, wobei die Umschalteinrichtung (11) einen Eingang für mindestens ein Steuersignal (SS) einer Störquelle (13) für die Messgröße aufweist, wobei die Umschalteinrichtung (11) derart ausgebildet ist, ohne Steuersignal (SS) den Bitstrom (BS) des Delta-Sigma-Modulators (6) zum Filter (7) durchzuschalten und bei Vorhandensein eines Steuersignals (SS) einen Ersatz-Bitstrom (EBS) durchzuschalten, der von der Vergleichseinheit (8) als zulässig beurteilt wird, sowie ein zugehöriges Verfahren.

## Beschreibung

Die Erfindung betrifft eine Vorrichtung und ein Verfahren zur Erfassung einer analogen Messgröße.

Aus der DE 10 2021 131 791 A1 ist ein Verfahren zum Betrieb einer wenigstens eine erste Komponente und eine zweite Komponente umfassenden elektrischen Schaltungsanordnung bekannt, wobei die Komponenten über ein Gleichstrom-Teilnetz der elektrischen Schaltungsanordnung elektrisch verbunden sind, wobei die erste Komponente in einem ersten Betriebspunkt mit einer ersten Taktung schaltet und die zweite Komponente in einem zweiten Betriebspunkt mit einer zweiten Taktung schaltet, wobei die Komponenten über eine Kommunikationsverbindung verbunden sind und in Abhängigkeit wenigstens einer eine aktuelle Wechselspannung in dem Gleichstrom-Teilnetz beschreibenden Störungsinformation eine erste Phasenlage ermittelt und zwischen der ersten Taktung und der zweiten Taktung eingestellt wird.

Derart getaktete Komponenten sind häufig Störquellen für Messgrößen. Soll beispielsweise in einem solchen Gleichstrom-Teilnetz die Spannung gemessen und überwacht werden, so führen diese überlagerten Wechselspannungen zu Problemen, insbesondere wenn bei Überspannungen sehr schnell abgeschaltet werden soll. Typische Reaktionszeiten bei Hochvolt-Traktionsnetzen liegen in der Größenordnung von 10 µs.

Dabei ist es bekannt, zur Messung von analogen Messgrößen bzw. insbesondere deren Digitalisierung Delta-Sigma-Modulatoren zu verwenden, die einen analogen Messwert in einen Bitstrom wandeln, der dann an ein Filter gegeben wird, an dessen Ausgang dann ein digitales Messsignal anliegt. Der Filter ist dabei vorzugsweise ein digitaler Tiefpassfilter. Grundsätzlich gilt für den Bitstrom, dass je positiver das Eingangssignal ist, desto mehr positive Bits sind enthalten und je negativer das Eingangssignal ist, desto mehr negative Bits sind enthalten. Ein Spezialfall stellt einen Eingangswert von Null dar. In diesem Fall sind genauso viele negative wie positive Bits enthalten und der Modulator gibt abwechselnd negative und positive Bits aus. Dies kann auch als Nullbitstrom bezeichnet werden. Wie bereits ausgeführt, sind derartige Messanordnungen mit Delta-Sigma-Modulatoren sehr schnell im Vergleich zu einer üblichen digitalen Signalverarbeitung in einem Mikrocontroller, allerdings treten auch hier die Probleme aufgrund kurzer Störimpulse aufgrund getakteter Störquellen auf, die häufig zu einer unnötigen Abschaltung führen.

Der Erfindung liegt das technische Problem zugrunde, eine Vorrichtung zur Erfassung und Überwachung einer analogen Messgröße zu schaffen, die schnell und robust gegen Störeinflüsse ist. Ein weiteres technisches Problem ist es, ein entsprechendes Verfahren zur Verfügung zu stellen.

Die Lösung des technischen Problems ergibt sich durch eine Vorrichtung mit den Merkmalen des Anspruchs 1 sowie ein Verfahren mit den Merkmalen des Anspruchs 8. Weitere vorteilhafte Ausgestaltungen der Erfindung ergeben sich aus den Unteransprüchen.

Die Vorrichtung zur Erfassung und Überwachung einer analogen Messgröße weist mindestens einen Sensor zur Erfassung der analogen Messgröße, einen analogen Eingangsfilter, einen Delta-Sigma-Modulator, einen nachgeordneten Filter und eine Vergleichseinheit auf. Der Delta-Sigma-Modulator ist derart ausgebildet, dem nachgeordneten Filter einen Bitstrom zuzuführen, wobei der Delta-Sigma-Modulator und der nachgeordnete Filter synchron getaktet sind. Weiter ist zwischen dem Delta-Sigma-Modulator und dem Filter eine Umschalteinrichtung angeordnet, wobei die Umschalteinrichtung mindestens einen Eingang für mindestens ein Steuersignal einer Störquelle für die Messgröße aufweist. Die Umschalteinrichtung ist derart ausgebildet, ohne Steuersignal der Störquelle den Bitstrom des Delta-Sigma-Modulators zum Filter durchzuschalten und bei Vorhandensein eines Steuersignals einen Ersatz-Bitstrom durchzuschalten, der von der Vergleichseinheit als zulässig beurteilt wird. Die Grundidee ist dabei, während der Störung das reale Messsignal abzuschalten und durch ein Pseudo-Signal (Ersatz-Bitstrom) zu ersetzen, das die Kriterien der Vergleichseinrichtung einhält, sodass die temporären Störungen nicht zu einer Fehlauslösung führen. Die Umschalteinrichtung wirkt dabei wie ein Multiplexer. Dabei wird der Ersatz-Bitstrom für die Zeit einer Schaltflanke sowie einer gewissen Einschwingzeit durchschaltet. Die Zeitspanne ist dabei ca. 1 µs, sodass noch ausreichend Zeit verbleibt (z.B. 9 µs), um das ungestörte Messsignal zu überwachen.

In einer Ausführungsform ist der Ersatz-Bitstrom ein Nullbitstrom, der vorzugsweise durch einen Teiler des Taktsignals erzeugt wird. Ist das Taktsignal beispielsweise ein 20 MHz-Takt, so wird beispielsweise ein 10 MHz- oder 5 MHz-Taktsignal generiert, das abwechselnd positive oder negative Bits aufweist, so wie dies bei einem Nullbitstrom der Fall sein soll.

In einer alternativen Ausführungsform ist ein Halteglied vorgesehen, das Ausgangssignale des Filters zwischenspeichert, wobei die Vorrichtung einen weiteren Delta-Sigma-Modulator aufweist, der eingangsseitig mit dem Halteglied verbunden ist und ausgangsseitig mit der Umschaltvorrichtung verbunden ist, wobei der weitere Delta-Sigma-Modulator den Ersatz-Bitstrom liefert. Die Idee dabei ist, als Ersatz-Bitstrom Messwerte kurz vor der Störung zurückzukoppeln, sodass diese Werte dichter an den realen Messwerten sind, was Vorteile bei der Auswertung hat, da diese Form des Ersatz-Bitstroms die Messwerte weniger verfälscht als ein Nullbitstrom.

In einer weiteren Ausführungsform ist der Sensor ein Spannungssensor, der weiter vorzugsweise eine Hochvolt-Spannung in einem Traktionsnetz eines Elektrofahrzeugs misst.

In einer weiteren Ausführungsform sind die Steuersignale Schaltflanken eines Pulswechselrichters oder eines DC/DC-Wandlers.

In einer weiteren Ausführungsform ist der weitere Delta-Sigma-Modulator als FPGA ausgebildet oder in einen Mikrocontroller implementiert, da die Anforderungen an den weiteren Delta-Sigma-Modulator geringer sind.

Hinsichtlich der verfahrensmäßigen Ausgestaltung kann vollinhaltlich auf die vorangegangenen Ausführungen Bezug genommen werden.

Die Erfindung wird nachfolgend anhand bevorzugter Ausführungsbeispiele näher erläutert. Die Figuren zeigen:
- Fig. 1: eine schematische Darstellung einer Vorrichtung zur Erfassung und Überwachung einer analogen Messgröße in einer ersten Ausführungsform und
- Fig. 2: eine schematische Darstellung einer Vorrichtung in einer zweiten Ausführungsform.

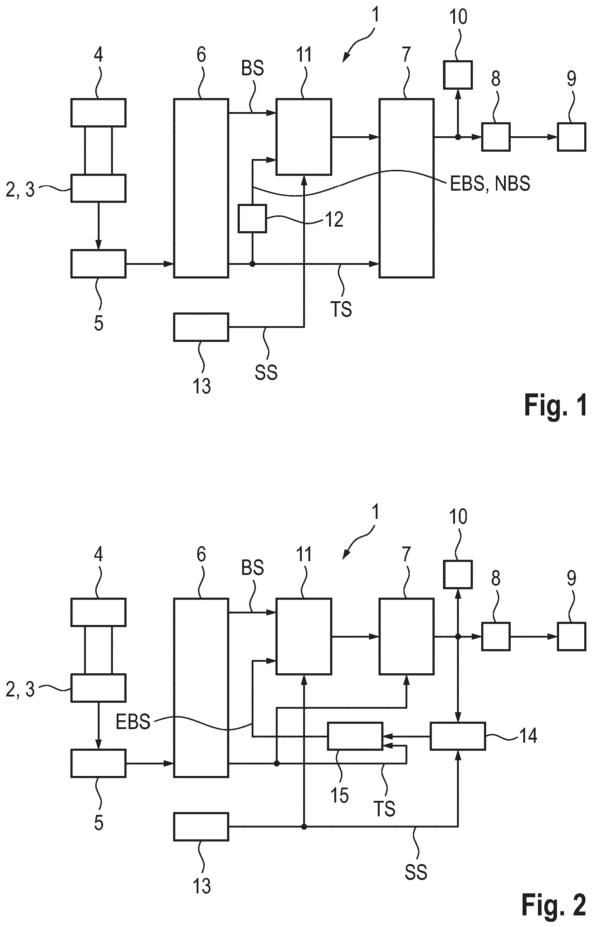

In der Fig. 1 ist eine Vorrichtung 1 zur Erfassung und Überwachung einer analogen Messgröße dargestellt. Die Vorrichtung 1 weist einen Sensor 2 zur Erfassung der analogen Messgröße auf. Im dargestellten Beispiel ist der Sensor 2 ein Spannungssensor 3, der mit DC-Anschlüssen 4 eines Traktionsnetzes eines Elektrofahrzeugs verbunden ist. Weiter weist die Vorrichtung 1 einen analogen Eingangsfilter (anti-aliasing filter) 5 auf, der die gefilterten Messgrößen einem Delta-Sigma-Modulator 6 als Eingangsgröße zuführt. Die Grenzfrequenz des als Tiefpassfilter wirkenden Eingangsfilters 5 ist dabei derart gewählt, dass die Abtastung des Delta-Sigma-Modulators 6 das Abtasttheorem einhält. Der Delta-Sigma-Modulator 6 arbeitet als AD-Wandler. Der Delta-Sigma-Modulator 6 ist als Hardware ausgebildet. Der Delta-Sigma-Modulator 6 erzeugt ein Taktsignal TS für ein digitales Filter 7. Das digitale Filter 7 wandelt den digitalen Bitstrom in einen digitalen Multi-Bit-Wert. Am Ausgang des digitalen Filters 7 ist eine Vergleichseinheit 8 angeordnet, die beispielsweise die Ausgangssignale des digitalen Filters 7 mit mindestens einem Schwellwert vergleicht, wobei, wenn der Schwellwert überschritten wird, eine Abschalteinrichtung 9 angesteuert wird, die beispielsweise als Relais ausgebildet ist. Weiter ist eine Speichervorrichtung 10 dargestellt, in der die digitalen Messwerte des digitalen Filters 7 abgespeichert werden. Weiter weist die Vorrichtung 1 eine Umschalteinrichtung 11 auf, die eingangsseitig den Bitstrom BS vom Delta-Sigma-Modulator 6 erhält. Weiter weist die Vorrichtung 1 einen Teiler 12 für das Taktsignal TS auf, der das Taktsignal TS z.B. durch zwei oder vier teilt. Das erzeugte Signal ist ein Ersatz-Bitstrom EBS in Form eines Nullbitstroms NBS, d.h. das Signal steht für einen Messwert Null, das gleich viele positive wie negative Bits aufweist. Der Ersatz-Bitstrom EBS wird ebenfalls eingangsseitig der Umschalteinrichtung 11 zugeführt. Der Umschalteinrichtung 11 wird ein Steuersignal SS einer Störquelle 13 zugeführt. Die Störquelle 13 ist beispielsweise ein Pulswechselrichter oder ein DC/DC-Wandler, wobei die Steuersignale SS die Schaltflanken der Leistungstransistoren der Störquelle 13 sind. Sind keine Steuersignale SS vorhanden, so schaltet die Umschalteinrichtung 11 den Bitstrom BS vom Delta-Sigma-Modulator 6 zum digitalen Filter 7 durch. Erzeugt hingegen die Störquelle 13 ein Schaltsignal SS, so schaltet die Umschalteinrichtung 11 auf den Ersatz-Bitstrom EBS um, der bei dieser Ausführungsform ein Nullbitstrom NBS ist. Diese Umschaltung bleibt für die Dauer des Schaltsignals plus einer gewissen Einschwingzeit bestehen, wobei dann anschließend wieder auf den Bitstrom BS des Delta-Sigma-Modulators 6 umgeschaltet wird. Der Ersatz-Bitstrom EBS wird also nur kurzzeitig im Zeitpunkt der Störung durchgeschaltet, sodass verhindert wird, dass die Vergleichseinheit 9 fälschlich eine Überspannung detektiert, die zu einer unnötigen Abschaltung führen würde.

In der Fig. 2 ist eine alternative Ausführungsform einer Vorrichtung 1 dargestellt, wobei gleiche Elemente mit gleichen Bezugszeichen versehen sind. Die Vorrichtung 1 weist im Gegensatz zur Ausführungsform gemäß Fig. 1 ein Halteglied 14 und einen weiteren Delta-Sigma-Modulator 15 auf. Das Halteglied 14 speichert die Ausgangssignale des digitalen Filters 7 zwischen. Das Halteglied 14 ist mit dem weiteren Delta-Sigma-Modulator 15 eingangsseitig verbunden, wobei der weitere Delta-Sigma-Modulator 15 den Ersatz-Bitstrom erzeugt. Der weitere Delta-Sigma-Modulator 15 wird synchron mit dem digitalen Filter 7 mit dem Taktsignal TS getaktet. Erzeugt dann die Störquelle 13 ein Schaltsignal SS, so werden die Daten aus dem Halteglied 14 dem weiteren Delta-Sigma-Modulator 15 zugeführt, der daraus einen Ersatz-Bitstrom EBS erzeugt, der von der Umschalteinrichtung 11 zum digitalen Filter 7 durchgeschaltet wird und weiter verarbeitet wird. Im Ergebnis erhält das digitale Filter 7 einen Ersatz-Bitstrom EBS, der dem Bitstrom BS vor dem Auftreten der Schaltsignale SS entspricht. Dadurch sind die Messwerte am Ausgang des digitalen Filters realistischer als die Messwerte aufgrund des Nullbitstroms NBS gemäß Fig. 1, wobei der Bauteileaufwand jedoch etwas größer ist.

### Bezugszeichenliste

- 1: Vorrichtung
- 2: Sensor
- 3: Spannungssensor
- 4: DC-Anschluss
- 5: analoger Eingangsfilter
- 6: Delta-Sigma-Modulator
- 7: digitales Filter
- 8: Vergleichseinheit
- 9: Abschalteinrichtung
- 10: Speichervorrichtung
- 11: Umschalteinrichtung
- 12: Teiler
- 13: Störquelle
- 14: Halteglied
- 15: Delta-Sigma-Modulator
- BS: Bitstrom
- EBS: Ersatz-Bitstrom
- NBS: Nullbitstrom
- TS: Taktsignal
- SS: Schaltsignal

## Patentansprüche

1. Vorrichtung (1) zur Erfassung und Überwachung einer analogen Messgröße, wobei die Vorrichtung (1) mindestens einen Sensor (2) zur Erfassung der analogen Messgröße,
einen analogen Eingangsfilter (5), einen Delta-Sigma-Modulator (6), einen nachgeordneten Filter (7) und eine Vergleichseinheit (8) aufweist, wobei der Delta-Sigma-Modulator (6) derart ausgebildet ist, dem nachgeordneten Filter (7) einen Bitstrom (BS) zuzuführen, wobei Delta-Sigma-Modulator (6) und Filter (7) synchron getaktet sind,
**dadurch gekennzeichnet, dass**
zwischen dem Delta-Sigma-Modulator (6) und dem Filter (7) eine Umschalteinrichtung (11) angeordnet ist, wobei die Umschalteinrichtung (11) einen Eingang für mindestens ein Steuersignal (SS) einer Störquelle (13) für die Messgröße aufweist, wobei die Umschalteinrichtung (11) derart ausgebildet ist, ohne Steuersignal (SS) den Bitstrom (BS) des Delta-Sigma-Modulators (6) zum Filter (7) durchzuschalten und bei Vorhandensein eines Steuersignals (SS) einen Ersatz-Bitstrom (EBS) durchzuschalten, der von der Vergleichseinheit (8) als zulässig beurteilt wird.

2. Vorrichtung nach Anspruch 1, **dadurch gekennzeichnet, dass** der Ersatz-Bitstrom (EBS) ein Nullbitstrom (NBS) ist.

3. Vorrichtung nach Anspruch 2, **dadurch gekennzeichnet, dass** der Ersatz-Bitstrom (EBS) durch einen Teiler (12) des Taktsignals (TS) erzeugt wird.

4. Vorrichtung nach Anspruch 1, **dadurch gekennzeichnet, dass** ein Halteglied (14) vorgesehen ist, dass das Ausgangssignal des Filters (7) speichert, wobei die Vorrichtung (1) einen weiteren Delta-Sigma-Modulator (15) aufweist, der eingangsseitig mit dem Halteglied (14) verbunden ist und ausgangsseitig mit der Umschalteinrichtung (11) verbunden ist, wobei der weitere Delta-Sigma-Modulator (15) den Ersatz-Bitstrom (EBS) liefert.

5. Vorrichtung nach einem der vorangegangenen Ansprüche, **dadurch gekennzeichnet, dass** der Sensor (2) ein Spannungssensor (3) ist.

6. Vorrichtung nach einem der vorangegangenen Ansprüche, **dadurch gekennzeichnet, dass** die Steuersignale (SS) Schaltflanken eines Pulswechselrichters sind.

7. Vorrichtung nach einem der Ansprüche 4 bis 6, **dadurch gekennzeichnet, dass** der weitere Delta-Sigma-Modulator (15) als FPGA ausgebildet ist oder in einem Mikrocontroller implementiert ist.

8. Verfahren zur Erfassung und Überwachung einer analogen Messgröße, wobei mittels mindestens einem Sensor (2) die analoge Messgröße erfasst und mittels eines analogen Eingangsfilters (5) gefiltert werden, wobei die gefilterten Werte mittels eines Delta-Sigma-Modulators (6) in einen Bitstrom (BS) digitalisiert werden und mittels eines Filters (7) in einen Multi-Bit-Wert gewandelt werden, wobei die digitalisierten Ausgangswerte des Filters (7) in einer Vergleichseinheit (8) mit mindestens einem Schwellwert verglichen werden, wobei der Delta-Sigma-Modulator (6) und der Filter (7) synchron getaktet werden, **dadurch gekennzeichnet, dass**
zwischen dem Delta-Sigma-Modulator (6) und dem Filter (7) eine Umschalteinrichtung (11) angeordnet ist, die mindestens einen Eingang für mindestens ein Steuersignal (SS) einer Störquelle (13) für die Messgröße aufweist, wobei die Umschalteinrichtung (11) ohne Steuersignal (SS) den Bitstrom (BS) des Delta-Sigma-Modulators (6) zum Filter (7) durchschaltet und bei Vorhandensein eines Steuersignals (SS) einen Ersatz-Bitstrom (EBS) zum Filter (7) durchschaltet, der von der Vergleichseinheit (8) als zulässig beurteilt wird.

9. Verfahren nach Anspruch 8, **dadurch gekennzeichnet, dass** der Ersatz-Bitstrom (EBS) ein Nullbitstrom (NBS) ist.

10. Verfahren nach Anspruch 8, **dadurch gekennzeichnet, dass** mittels eines Haltegliedes (14) Ausgangssignale des Filters (7) zwischengespeichert werden, die dann einem weiteren Delta-Sigma-Modulator (15) zugeführt werden, wobei der weitere Delta-Sigma-Modulator (15) mit der Umschalteinrichtung (11) verbunden ist und den Ersatz-Bitstrom (EBS) liefert.
